# EUROPEAN PATENT APPLICATION

(11) **EP 4 800 594 A1**
(43) Date of publication of application: **02.09.2026**
(21) Application number: 25160303.1
(22) Date of filing: 26.02.2025
(51) Int. Cl.: G06F 30/10, G06F 30/27, G06N 3/045, G06N 3/0455, G06T 17/00

(54) **METHOD AND SYSTEM FOR CREATING A 3D CAD MODEL**

(71) Applicant: Siemens Aktiengesellschaft, 80333 München (DE)
(72) Inventor: Eisert, Kilian, 82008 Unterhaching (DE); Fuchs, Bertram, 83410 Laufen (DE); Haag, Aaron, 69256 Mauer (DE); Kacan, Altay, 81737 München (DE); Lohse, Oliver, 85604 Zorneding (DE)
(74) Representative: Siemens Patent Attorneys

(57) **Abstract**

A method for creating a 3D CAD model comprising the steps:
- receiving a text containing a natural language description of the 3D model,
- transferring the text to a large language model,
- receiving, from the large language model, a response containing one or more graph tokens that describe the 3D model in a graph-based embedded encoding,
- converting, in a second neural network, the graph tokens into a graph-based representation of a 3D model,
- converting the graph-based representation to a CAD model representation.

## Description

The present invention relates to a method and system for creating a 3D CAD model from a user intent given as, e.g., a text containing a natural language description of the desired 3D model.

Both the initial design of a 3D CAD model and subsequent modifications are traditionally manual processes that are time-intensive and thus costly. Even for small changes to the 3D geometry expert knowledge about manufacturability and using CAD software is required. Rule-based algorithmic approaches for adjusting models may easily fail or result in broken 3D models, especially in the case of complex models. This is due to the high dependency of geometry on modelling history and the geometric constraints enforced on the model. This problem is further complicated by the fact that it is possible to create the same geometry with different modelling operations and that every CAD engineer has their own unique way of creating 3D models.

Generative Al has shown impressive performance in other domains such as natural language processing, image generation, and video generation. It can be used to generate samples that are similar to examples encountered in a large dataset and can be conditioned on user input to guide the generation.

However, using state-of-the-art generative Al methods to generate 3D CAD data is problematic. For example, STEP files (an open 3D format - ISO 10303) used to represent 3D CAD parts contain redundancy, are hard to decode solely based on the text, and contain information that is irrelevant for the 3D geometry. A STEP file for even a small part can be so large that a large language model may struggle to grasp the context and may thus be inefficient or outright fail at generating it correctly.

It is an object of the present invention to provide a method and system for creating a 3D CAD model from a user intent given as a text containing a natural language description of the desired 3D model that avoid the described problems.

A solution is provided by the method with the features of claim 1. A further solution is provided by the system with the features of claim 11.

The method according to the invention for creating a 3D CAD model comprises the steps:
- receiving computer-stored data containing a user-defined intent describing the desired 3D CAD model,
- transferring the text to a large language model (LLM),
- receiving, from the large language model, a response containing one or more graph tokens that describe the 3D model in a graph-based embedded encoding,
- converting, in a second neural network, the graph tokens into a graph-based representation of a 3D model,
- converting the graph-based representation to a CAD model representation.

The system according to the invention for creating a 3D CAD model comprises a user interface means for receiving computer-stored data containing a user-defined intent describing the desired 3D CAD model. It further comprises data transmission means arranged to transfer the text to a large language model and arranged to receive, from the large language model, a response containing one or more graph tokens that describe the 3D model in a graph-based embedded encoding. A second neural network is arranged to convert the tokens into a graph-based representation of a 3D model and the system comprises means for converting the graph-based representation to a CAD model representation.

The computer-stored data containing a user-defined intent describing the desired 3D CAD model can be of different modalities. For example, it can be a text containing a natural language description of the 3D model. Additionally or alternatively, it can be a two-dimensional sketch or an existing 3D model that has to be adapted in some way. The skilled person understands that the user-defined intent is not the exact resulting 3D CAD model even if it is a file but is a less than complete rendition of what the resulting 3D CAD model is to be.

Advantageously, in the method and system according to the invention the large language model no longer directly interfaces with a 3D model representation in a typical format such as STEP. Instead, the LLM's output is post-processed to create the 3D CAD model. This post-processing comprises converting the LLM's output from an embedded form into a graph-based representation of the 3D CAD model and only from the graph-based representation to a CAD model form, particularly a STEP file representation.

The LLM in turn is trained and required to only output the embedded form of the desired 3D model. This embedded form is much smaller than a typical STEP file or similar representation which improves the LLM's accuracy in creating it.

The response may also contain text tokens.

### Definitions:

A 3D CAD model is a three-dimensional geometric body which is described by its boundaries, e.g. polygonal faces and their topology. The description is lossless or complete in the sense that it is not pixelated such as a point cloud. The 3D CAD model is represented in computer memory or file in a format such as STEP. The 3D CAD model may include information that is not purely geometrical (product manufacturing information, PMI).

Product Manufacturing Information (PMI) is design, manufacturing, quality, and other data included in a 3D CAD file. It can convey information such as geometric dimensions and tolerances, surface finish, and material specifications.

Large language models (LLMs) are advanced artificial intelligence systems designed to understand and generate human-like text based on vast amounts of data. They use deep learning techniques, particularly neural networks, to process and predict the next word in a sequence, enabling them to perform tasks such as translation, summarization, and conversation. Examples of LLMs include GPT-3 and GPT-4. The size of the neural network of a large language model, i.e. the number of its parameters, is typically thought to be at least 50 million, particularly at least 500 million.

The output of a large language model is in the form of tokens, i.e. numbers, that are usually subsequently converted to words to form a natural language response. Tokens can however be used in other ways. In the present invention, graph tokens are tokens that are preferentially directly used as input for the second neural network without conversion to natural language. The response of the large language model may comprise both tokens representing natural language such as "This is the graph you requested" and the graph tokens that represent the 3D model. To allow distinguishing between the types of tokens the graph tokens may be marked. For example, the graph tokens may be enclosed in tokens marking them in the manner of XML or HTML tags.

Further features that may be added alone or together in exemplary embodiments of the invention include:
In an advantageous embodiment, the graph-based representation comprises feature data of the 3D model, the feature data comprising spatial coordinates of the vertices of the model, and adjacency data for vertices, edges and faces of the 3D model. This data is sufficient to describe the 3D structure of a 3D CAD model, i.e. of an object that is to be created using the user intent.

The feature data may additionally comprise product manufacturing information for vertices, edges and/or faces of the 3D model. Thus, information that extends beyond purely geometrical may be transported in the graph-based representation.

The adjacency data may be filtered to comprise only non-redundant adjacency information. In other words, the graph-based representation may be structured to not include duplicate or useless data such as edge-edge relations, as edges only relate to vertices and faces, not to other edges.

The adjacency data may be implemented as a topology matrix wherein edges of the 3D model correspond to a first axis and vertices and faces of the 3D model correspond to a second axis with entries of 1 and 0 where 1 denotes a vertex that is part of the edge or an edge that is part of a face. This implementation of the adjacency data is free of redundancy and unused data.

The second neural network may be a decoder of an encoder-decoder model. An encoder-decoder model is a type of neural network architecture commonly used in tasks that involve transforming one sequence into another, such as machine translation, text summarization, and image captioning.

The encoder of the model processes the input sequence and compresses it into a fixed-size context vector. It captures the essential information from the input data. The decoder takes the context vector from the encoder and generates the output sequence. It uses the information in the context vector to produce the desired output, step by step. An example of an encoder-decoder model is the Transformer architecture, which has been highly effective in natural language processing tasks.

The decoder may be trained together with an associated encoder with the steps:
- providing a plurality of 3D models in a CAD model representation,
- choosing a model of the plurality of 3D models,
- converting the 3D model to a first graph-based representation,
- converting, with the encoder, the first graph-based representation to an embedded representation,
- converting, with the decoder, the embedded representation to a second graph-based representation,
- providing feedback to the decoder and the encoder based on a difference between the first and second graph-based representation of the 3D model.

Preferentially the described training steps are performed for many or all of the plurality of 3D models.

Advantageously the described training process for the encoder decoder model is unsupervised, i.e. it does not require labelling of the training data which in turn would require manual effort.

A fine-tuning of the large language model may be performed comprising the steps:
- choosing a model of the plurality of 3D models,
- providing a textual description of the model,
- providing a textual input to the large language model that comprises the textual description and prompts it to output graph tokens and receiving the output of the large language model,
- converting the model to an embedded representation using the encoder,
- providing fine-tuning feedback to the large language model based on differences between the embedded representation and the graph tokens.

The same plurality of 3D models may be used for fine-tuning the large language model and training the encoder decoder model.

Embodiments of the present invention are now described with reference to the accompanying drawings to which the invention is not limited. The illustrations of the drawings are in schematic form. It is noted that in different figures, similar or identical elements use the same reference signs.
Fig. 1 shows a simple three-dimensional object with vertices, edges and faces,
Fig. 2 shows a simplified form of an adjacency matrix for vertices, edges and faces, containing redundant information,
Fig. 3 shows an example for a topology matrix obtained from the adjacency matrix,
Fig. 4 shows an example for a feature matrix,
Fig.5 shows a training process for an encoder-decoder model,
Fig.6 shows a finetuning process for a pretrained large language model incorporating the decoder of the encoder-decoder model,
Fig.7 shows the structure of a system for generating 3D models from user-provided intent prompts.

In the present example for the invention, several components are being used.

A first component is a reduced 3D CAD model representation that is suitable for consumption and generation of 3D CAD models using machine learning. The representation has common elements with the Boundary Representation (B-Rep) as used in the Open CASCADE technology but uses a reduced number of entities.

This is done by only storing the entities of vertex, edge, and face in so called adjacency and feature matrices T, U. Using a rule-based approach the missing entities, such as wires can be reconstructed. This can be done using a geometric modeling kernel, e.g. the Python OCC library which implements the Open CASCADE Technology or Parasolid.

In this way, the reduced representation space is limited to the most basic geometric primitives like lines, planes, circles, spheres, cylinders, cones, and tori.

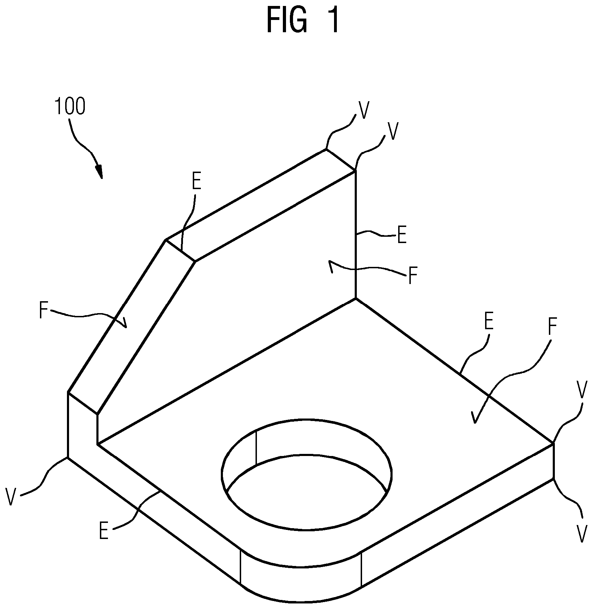

Figure 1 shows a simple 3D object 100. It consists of a number of vertices (points in space) V. Pairs of vertices V are connected by edges E. Various groups of connected edges E in turn form faces F. The faces F form the outer boundaries of the object 100.

The B-rep connectivity in the present representation can thus be constructed as a heterogeneous undirected graph with nodes of the graph being vertices V, edges E and faces F of the B-Rep which can be encoded in an adjacency matrix A. As there can only be graph edges from vertices to edges as well as graph edges from edges to faces, zero submatrices exist. Furthermore, as the adjacency matrix is symmetric (undirected graph), only one of the submatrix blocks VE / EV, EF / FE is required.

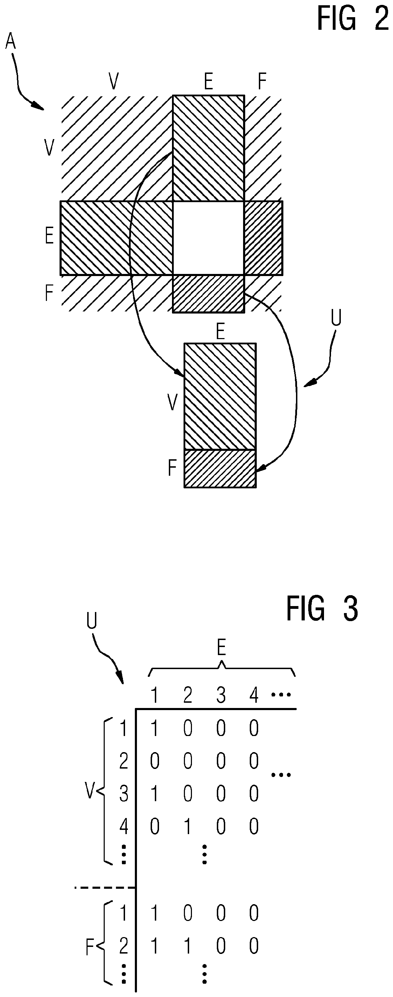

This is depicted in figure 2 that shows the entire adjacency matrix A. Both axes of the adjacency matrix A have columns and rows corresponding to each of the vertices V, faces F and edges E. The entries are either 0 or 1, corresponding to vertices V forming an edge E and edges E forming a face F. Other combinations are invalid (e.g., vertices do not form vertices) and thus, 0. Parts of the adjacency matrix A form the topology matrix U. The topology matrix U is, in other words, the adjacency matrix A reduced to only valid and non-redundant values. In summary, all required information of the proposed 3D-CAD representation can be condensed into the non-zero entries in the topology matrix U.

Figure 3 shows a simplified and abbreviated example of a topology matrix U with some exemplary values. Note that the row and column axes show an index of the respective face, vertex and edge for better visualization; these are not part of the actual topology matrix U. The vertices are usually three-dimensional and therefore, vertex 1 could have the coordinates (0, 125, 75), vertex 2 could have the coordinates (125, 125, 75) and so on.

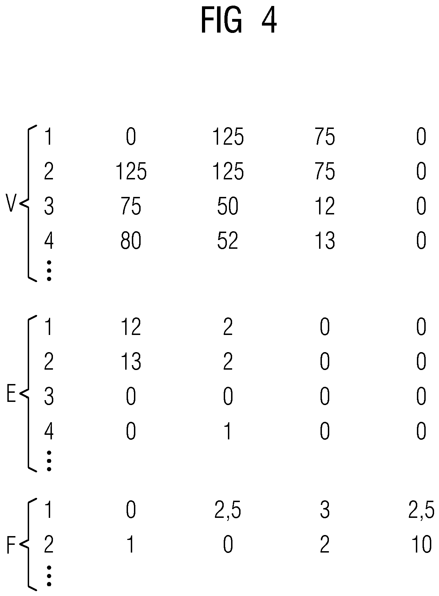

This coordinate information is stored in a feature matrix T which, additionally, supports encoding of relevant information such as face related product manufacturing information (PMI). Due to the difference in number of features for faces F, edges E and vertices V, non-necessary values are zero-padded and not learnt. Figure 4 shows an example of the feature matrix F containing coordinate information for some vertices V as well as purely exemplary values for edges and faces.

The two matrices T and U provide a complete representation of the B-rep information required for the supported geometric primitives and are used in the other components for 3D CAD model training and 3D CAD model generation as described in the subsequent sections.

A second component of the present example is an unsupervised machine learning model which can learn the distribution of 3D CAD models using the representation of the previously described first component.

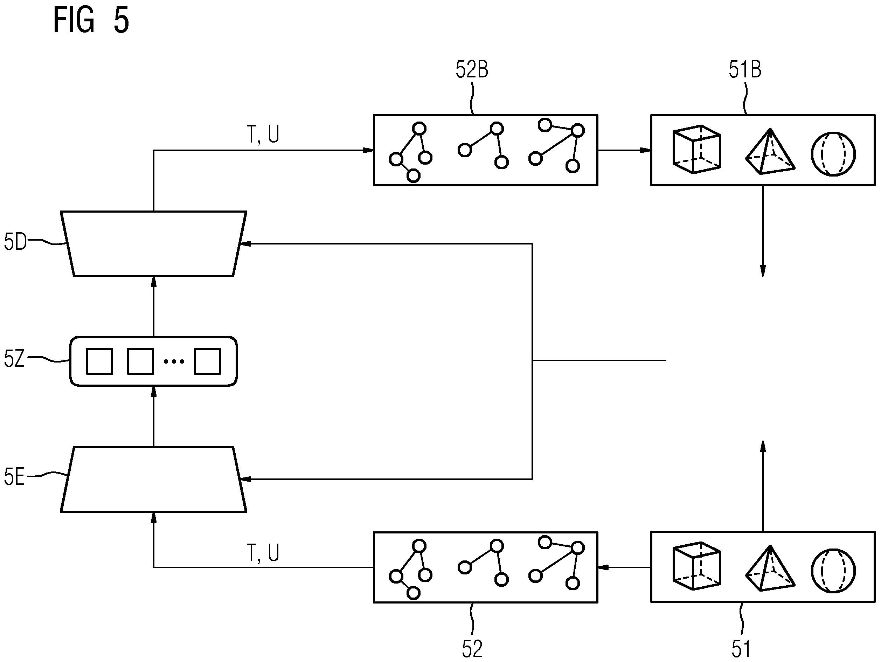

For learning a discretized graph representation, an encoder-decoder model is trained in an unsupervised paradigm. Figure 5 shows this training process. The encoder-decoder model comprises an encoder 5E and a decoder 5D both of which are neural networks.

In a first training step, a synthetic dataset 51 of 3D-CAD parts is provided. The dataset 51 of 3D-CAD parts must be provided but may be generated automatically, e.g. through randomized combinations of unions and differences of basic geometric solids.

The following steps are performed for each part of the dataset 51 at least once.

In a second training step, one model of the dataset 51 is converted into a 3D-CAD graph representation form 52 as previously described, i.e. a feature matrix T and a topology matrix U.

In a third training step, the graph representation 52 is passed to the encoder 5E and is converted into a latent space representation (discretized graph representation) 5Z. In a fourth training step, this discretized graph representation 5Z which comprises low dimensional data is passed into the decoder 5D and converted back into a graph representation 52B. Subsequently in a fifth training step the graph representation is converted into a 3D-CAD model 51B.

This training is performed in an unsupervised manner. Each resulting 3D CAD model 51B that is an output of the process is, in a sixth training step, compared with the model as it had been when used as an input to the training process and the differences are used as feedback to the encoder-decoder model 5E, 5D to improve its performance by updating the weights used in its neural network. Therefore, no labelling of results is required and the training of the decoder and encoder 5E, 5D can be done in an efficient way.

The training results in a decoder 5D which is used in the following components.

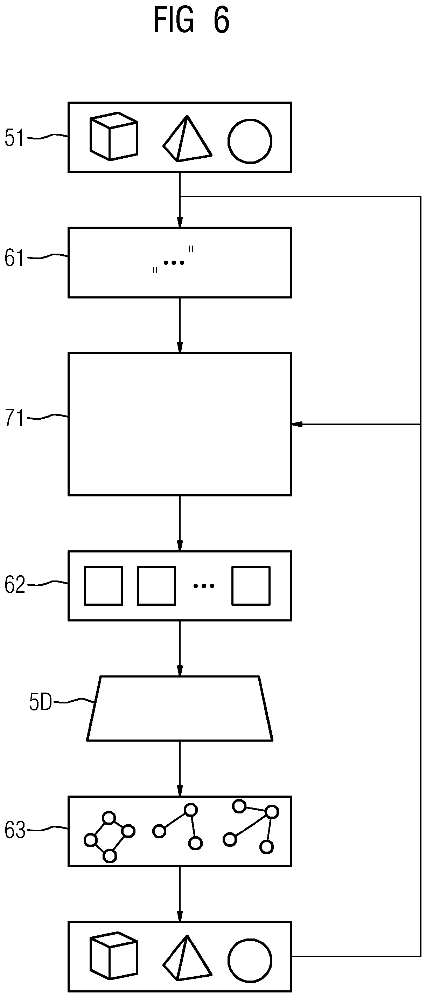

A further component of the system is a large language model 71. The large language model 71 can be one of the existing commercial or free models that allow fine-tuning. A fine-tuning process for the large language model 71 is shown in figure 6.

For the fine-tuning process, the dataset 51 of 3D CAD models is re-used. Some or all of the models of the dataset 51 are processed with the following fine-tuning steps.

In a first fine-tuning step, a textual representation of the model is obtained. In a simple example, this textual representation may be "a cylinder of 10 cm height and 8 cm diameter". In a second fine-tuning step, a prompt 61 for the large language model 71 is formed using this textual representation and transmitted to the large language model 71 as input.

In a third fine-tuning step, the output 62 of the large language model 71 is received and transmitted to the decoder 5D, which transforms the output into a graph representation 63. Subsequently in a fourth fine-tuning step the graph representation 63 is converted into a 3D-CAD model. Differences between the graph representation of the original 3D model and the generated 3D-CAD-model are used as feedback to the large language model 71 in a fifth fine-tuning step.

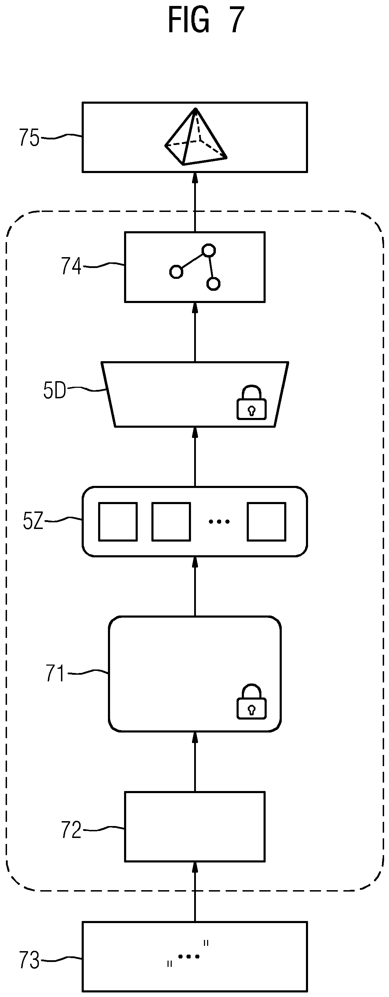

Figure 7 shows the architecture of a 3D-CAD part generator system 70. The system 70 allows entering a user intent, usually as a textual prompt 73. It generates a 3D CAD model from the user intent. The system 70 is shown in a simplified way.

The system comprises a user intent input interface 72 that allows entering the user intent. This interface 72 can take many forms, e.g. a user interface can be shown on a PC and input be passed on via the internet.

Input 73 that is entered at the interface 72 is forwarded to LLM 71. The LLM 71 processes the input and produces an output 5Z in the form of tokens. As the LLM 71 is trained and fine-tuned as described above it produces an output that, provided it works correctly, contains a discretized graph representation 5Z as described above.

This discretized graph representation 5Z is forwarded to decoder 5D which is trained to process the discretized graph representation 5Z as described above. The result of this processing is a matrix representation 74 of a 3D object using the matrices T, U as described above.

These matrices T, U, which describe vertices V, edges E and faces F of an object, can be converted to a 3D CAD representation 75 of the object, e.g. in a commonplace CAD file format. This last conversion is deterministic and can easily be done by e.g. a python script.

### List of reference numbers

- 100: three-dimensional object
- V: vertex
- E: edge
- F: face
- A: adjacency matrix
- U: topology matrix
- T: feature matrix
- 5E: encoder
- 5D: decoder
- 51: dataset of 3D models
- 52, 63, 74: 3D-CAD graph representation
- 5Z: latent space representation
- 52B: graph representation
- 61, 73: prompt for the large language model
- 62: output of the large language model
- 70: 3D CAD part generator system
- 71: large language model
- 72: user input interface
- 75: 3D CAD representation of a model

## Claims

1. Method for creating a 3D CAD model (75) comprising the steps:
- receiving computer-stored data containing a user-defined intent describing the desired 3D CAD model,
- transferring the data to a large language model (71),
- receiving, from the large language model (71), a response (5Z) containing one or more graph tokens that describe the 3D model in a graph-based embedded encoding,
- converting, in a second neural network (5D), the graph tokens into a graph-based representation (74) of a 3D model,
- converting the graph-based representation (74) to a CAD model representation (75).

2. The method of claim 1, wherein a graph token is a marked section of the response (5Z) containing 3D model data.

3. The method of claim 1 or 2, wherein the CAD model representation (75) is a computer-stored, particularly memory-stored or file-stored, representation of the 3D data in a file format, particularly a STEP file.

4. The method of any of the preceding claims, wherein the graph-based representation (52, 63, 74, 52B) of a 3D structure comprises
- feature data of the 3D model, the feature data comprising spatial coordinates of the vertices (V) of the model,
- adjacency data for vertices, edges and faces (V, E, F) of the 3D model.

5. The method of claim 4, wherein the feature data comprises product manufacturing information for vertices, edges and/or faces (V, E, F) of the 3D model.

6. The method of claim 4 or 5, wherein the adjacency data is filtered to comprise only non-redundant adjacency information.

7. The method of any of claims 4, 5 or 6, wherein the adjacency data comprises a topology matrix (T) wherein edges (E) of the 3D model correspond to a first axis and vertices and faces (V, F) of the 3D model correspond to a second axis with entries of 1 and 0 where 1 denotes a vertex that is part of the edge or an edge that is part of a face.

8. The method of any of the preceding claims, wherein the second neural network (5D) is a decoder (5D) of an encoder-decoder (5D, 5E) model.

9. The method of any of the preceding claims, wherein the second neural network (5D) is trained together with an associated encoder (5E) with the steps:
- providing a plurality of 3D models (51) in a CAD model representation,
- converting the 3D models (51) to a first graph-based representation (52),
- converting, with the encoder (5E), the first graph-based representation (52) to an embedded representation (5Z),
- converting, with the second neural network (5D), the embedded representation (5Z) to a second graph-based representation (52B),
- providing feedback to the second neural network (5D) and the encoder (5E) based on a comparison of the first and second graph-based representation (52, 52B) of each of the 3D models.

10. The method of claim 9, wherein fine-tuning of the large language model (71) is performed comprising the steps:
- choosing a model of the plurality of 3D models (51),
- providing a textual description of the model,
- providing a textual input (62) to the large language model (71) that comprises the textual description and prompts it to output graph tokens and receiving the output (62) of the large language model (71),
- converting the model to an embedded representation using the encoder (5E),
- providing fine-tuning feedback to the large language model (71) based on differences between the model and the output.

11. System (70) for creating a 3D CAD model comprising:
- A user interface means (72) for receiving data containing a user-defined intent describing the desired 3D CAD model,
- data transmission means arranged to transfer the text to a large language model (71) and arranged to receive, from the large language model (71), a response containing one or more graph tokens that describe the 3D model in a graph-based embedded encoding,
- a second neural network (5D) arranged to convert the tokens into a graph-based representation of a 3D model,
- means for converting the graph-based representation to a CAD model (75) representation.
